# EUROPEAN PATENT APPLICATION

(11) **EP 4 819 791 A1**
(43) Date of publication of application: **07.10.2026**
(21) Application number: 25167934.6
(22) Date of filing: 02.04.2025
(51) Int. Cl.: H10D 18/01, H10D 18/80, H10D 62/10, H10D 62/17, H10D 64/27

(54) **BIDIRECTIONAL THYRISTOR WITH PERMANENT SHORT-CIRCUIT FAIL MODE, MODULAR MULTILEVEL CONVERTER CELL AND METHOD PROTECTING THE CONVERTOR**

(71) Applicant: Hitachi Energy Ltd, 8050 Zürich (CH)
(72) Inventor: Vobecky, Jan, 16000 Praha 6 (CZ); Pina, Libor, 19300 Praha 9 (CZ)
(74) Representative: Michalski Hüttermann & Partner mbB

(57) **Abstract**

The invention relates a protection circuit (100) for protecting modular multilevel converter, MMC, cell, a MMC cell (1000) and a protection method. The protection circuit (100) comprises a bypass semiconductor device (1) with a first thyristor structure (10) and a second thyristor structure (20) connected in antiparallel. The first thyristor structure (10) comprises a first trigger region (61) and a first emitter region (71). The second thyristor structure (20) comprises a second trigger region (62) and a second emitter region (72). The disposition of the trigger regions (61, 62) and of the emitter regions (71, 72) being such that in response to a failure of the MMC cell, the first thyristor structure (10) fails to a permanent short circuit by a first gate pulse current between the first trigger region (61) and the first emitter region (71), while the second thyristor structure (20) fails to a permanent short circuit by a second gate pulse current between the second trigger region (62) and the second emitter region (72).

## Description

### Technical Field

The invention relates to the technical field of electronic circuits, in particular, a protection circuit with a bypass semiconductor device, a modular multilevel converter, MMC, cell and a method for protecting the MMC.

### Background Art

Modular multilevel converters, MMC, have gained significant attention in power electronics due to their modular design, scalability in terms of current and voltage, and their ability to significantly improve harmonic performance and reduce energy losses compared to conventional two-level and three-level converters. The MMC concept encompasses various topologies, among which the Half-Bridge, HB, and mixed Half-Bridge - Full-Bridge, HB-FB, MMC configurations are of particular interest in high-power applications.

To ensure reliable operation under fault conditions, MMCs require robust fault protection mechanisms. In particular, they rely on power semiconductor switches such as Insulated Gate Bipolar Transistors, IGBTs, or Integrated Gate Commutated Thyristors, IGCTs, with long-term short-circuit failure mode, SCFM, capability. Alternatively, special protection circuits are employed in parallel with the MMC cell or the switching elements in a typical MMC cell. These protection circuits generally utilize pyrotechnic switches or circuit-commutated thyristors, which can be either unidirectional or bidirectional.

Existing unidirectional thyristors can be triggered under high voltage to share system surge currents, thereby preventing damage to the power semiconductor devices. Commercially available bidirectional thyristors, on the other hand, incorporate a permanent gate-to-cathode short within their ceramic housing. These devices act as bypass elements but do not contribute to surge current sharing. Additionally, they require high voltages to break down into a short-circuit state. This can result in excessive di/dt stresses, leading to damage to other power semiconductor devices in the MMC cell and uncontrolled energy discharge from the cell capacitor.

Moreover, a critical failure scenario arises when the corresponding power semiconductor device experiences a short-circuit failure, leading to a low cathode-anode voltage across the bidirectional thyristor. This condition is particularly challenging during a "black start", where the MMC cell must be shorted with zero voltage across the cell capacitor. In such cases, conventional thyristors are unable to be trigger normally, thereby limiting the energy required to permanently short the MMC cell.

Document EP 4 007 139 B1 provides a MMC module comprising a bidirectional switchable bypass device which can be triggered into a permanent ON state in response to a single trigger pulse. However, this bidirectional bypass device requires a high voltage difference across its first and second main electrodes to be triggered and is unable to handle the fault situation where the anode voltage is low.

Accordingly, there is a need for an improved protection circuit that ensures reliable and effective fault protection for different MMC cells under all possible failure scenarios, specifically during the "black start", to address the limitations of existing protection circuits.

### Summary of invention

It is therefore an object of the invention to provide an improved protection circuit with a bidirectional bypass semiconductor device, which is specifically designed to achieve reliable bypassing and permanent shorting under arbitrary fault conditions of MMC cells, thereby enhancing robustness and operational safety of MMC.

The object of the invention is solved by the independent claims. Preferred implementations are detailed in the dependent claims.

Thus, the object is solved by a protection circuit for a modular multilevel converter, MMC, comprising a bypass semiconductor device. The protection circuit comprises:
a semiconductor body extending in an axial direction with a first surface and a second surface,
a first thyristor structure and a second thyristor structure antiparallel connected to each other and sharing the semiconductor body,
a first gate electrode and a first main electrode disposed on the first surface and spaced from each other, and
a second gate electrode and a second main electrode disposed on the second surface and spaced from each other, whereby
the first thyristor structure comprises a first trigger region facing and electrically connected to the first gate electrode and a first emitter region facing and electrically connected to the first main electrode,
the second thyristor structure comprises a second trigger region facing and electrically connected to the second gate electrode and a second emitter region facing and electrically connected to the second main electrode, and
in response to gate driving voltages *V_{G}* applied to the first gate electrode and the second gate electrode, the first thyristor structure is configured to fail to a permanent short circuit by a first gate pulse current induced between the first trigger region and the first emitter region, while the second thyristor structure is configured to fail to a permanent short circuit by a second gate pulse current induced between the second trigger region and the second emitter region.

Here, the first main electrode functions as a cathode for the first thyristor structure and an anode for the second thyristor structure, while the second main electrode functions as a cathode for the second thyristor structure and an anode for the first thyristor structure. Thus, with respect to the blocking direction, the first and second thyristor structures are arranged in antiparallel, sharing the same semiconductor body and the main electrodes. The first gate electrode and the second gate electrode function respectively for the first and second thyristor structures.

In addition, the trigger regions may have a first conductivity type of P-type, and the emitter regions may have a second conductivity type of N-type, or vice versa.

A key point of the present invention is the symmetrical design of the bypass semiconductor device. With this design, the protection circuit can serve to protect the FB and FB-HB MMC cells by adapting to the changing polarity of a main electrode voltage or AC voltages. The gates of the two thyristor structures can be activated at the same time regardless of the main electrode voltage polarity.

Moreover, a combination of the tigger regions and the corresponding emitter regions enables the breakdown of the thyristor structures even when the main electrode voltage is low. When the main electrode voltage is lower than the gate driving voltages applied to the gate electrodes, most of the gate pulse current can concentrate and flow along the trigger regions to the emitter regions, leading to a high current density that accurately destroys both blocking junctions of the thyristor structures within a short response time. Consequently, the protection circuit can offer reliable bypass under arbitrary fault conditions.

According to a preferred implementation of the present invention, the first thyristor structure may comprise a first anode region facing and electrically connected to the second main electrode, the second thyristor structure may comprise a second anode region facing and electrically connected to the first main electrode. In a scenario that a magnitude of a voltage V between the first main electrode and the second main electrode is larger than the gate driving voltages *V_{G}* applied to the first trigger region and the second trigger region, the first thyristor structure may further be configured to fail to the permeant short circuit by a first surge current between the first anode region and the first emitter region, or the second thyristor structure may further be configured to fail to short by a second surge current between the second anode region and the second emitter region.

In this design, the first anode region may function as an anode region of the first thyristor structure, while the second anode region may function as an anode region of the second thyristor structure. When the main electrode voltage *V* is higher than the gate driving voltages *V_{G}* applied to the gate electrodes, one of the first and second thyristor structures can be triggered by the gate driving voltages following classical thyristor operation. In addition to the lateral current between the trigger regions and the emitter regions, current may also flow between the emitter and anode regions of the triggered thyristor structure to destroy the blocking junctions. The anode regions may have a conductivity type same as the trigger regions.

According to a preferred implementation of the present invention, the first gate electrode may comprise a first guiding region extending in a radial direction on the first surface and the first trigger region may extend along and be electrically connected to the first guiding region. The second gate electrode may comprise a second guiding region extending in a radial direction on the second surface and the second trigger region may extend along and be electrically connected to the first guiding region.

Here, the guiding regions and the trigger regions may extend in a radial direction and thereby the gate pulse current may be induced and flow between ends of the trigger regions and corresponding emitter regions. With this design, local current crowding may be enhanced at the end of the trigger regions so as to further improve robustness of the protection circuit.

According to a preferred implementation of the present invention, the first thyristor structure may comprise multiple first trigger regions and multiple first emitter regions in the semiconductor body, and the second thyristor structure comprises multiple second trigger regions and multiple second emitter regions in the semiconductor body.

Specifically, each thyristor structure may comprise multiple pairs of the trigger regions and the emitter regions distributed throughout the semiconductor body. Gate pulse current may be induced and flow between the multiple pairs of the trigger regions and the emitter regions so as to creating potential failure points in the blocking junctions. This can increase further increase the area of shorted region, leading and hereby lowering the electrical resistance between the shorted electrodes and improve more effective circuit protection under fault conditions.

Optionally, the number of the first and the second sacrificial regions are between 2 to 8, preferably, between 3 to 6. The multiple pairs of the trigger regions and emitter regions may be rotationally symmetrical with respect to a central axis of the semiconductor body.

According to another implementation of the present invention, the bypass semiconductor device may further comprise a breakover diode encircling the first and the second thyristor structures. The breakover diode structure (90) may be configured to be punched through when the voltage *V* between the first and the second main electrodes exceeds the breakover voltage *V_{BO}.*

In this implementation, the bypass semiconductor device is then equipped with parallel breakover diode structure. When it comes to the fault condition with high applied voltage, the breakover diode structure may be subjected to punch-through or breakdown effect when the voltage between the first and the second main electrodes exceeds the breakover voltage of the breakover diode.

Specifically, the semiconductor body may comprise a third trigger region disposed in the semiconductor body facing the first main electrode. The third trigger region may be disposed in a circular region encircling the first emitter region and be spaced from the first emitter region. The third trigger region may have a conductivity type same as the first tigger region. The semiconductor body may further comprise a fourth trigger region disposed in the semiconductor body facing the second main electrode. The fourth trigger region may be disposed in a circular region encircling the second emitter region and be spaced from the second emitter region. The fourth trigger region may have a conductivity type same as the second trigger region.

Optionally, the semiconductor body may comprise a junction termination region encircling the breakover diode structure and have a reverse breakdown voltage *V_{BRJ}* higher than the breakover voltage *V_{BO}* of the breakover diode structure.

When it comes to the breakdown of the semiconductor body due to the high applied voltage, the breakdown can happen only in the bulk inside the junction termination region, thereby avoiding arcing at the periphery of the semiconductor body, which could lead to explosion.

According to a preferred embodiment of the present invention, the semiconductor body may comprise a first blocking junction and a second blocking junction, the first blocking junction may comprise a first protruding platform extending toward the first trigger region and the first emitter region, and the second blocking junction may comprise a second protruding platform extending toward the second trigger region and the second emitter region.

Here, the first blocking junction is located near the first surface while the second blocking junction is located near the second surface. In this implementation, beneath the trigger regions and the emitter regions, the blocking junctions formed by the base layers of the semiconductor body may be located closer to the surfaces in the axial direction than in other regions. These shallower blocking junctions can make the device more susceptible to damage, which may in turn reduce a fail-to-short-circuit response time of the semiconductor device and lower the required gate driving voltages for triggering.

According to a preferred implementation of the present invention, a thickness of the first main electrode may be larger than a thickness of the first guiding region and a thickness of the second main electrode may be larger than a thickness of the second guiding region.

Preferably, the bypass semiconductor device may further comprise a first metal contact layer attaching to the first main electrode and a second metal contact layer attaching to the second main electrode. The first metal contact layer may extend toward the first guiding region and define a first gap in the axial direction between the first metal contact layer and the first guiding region. The second metal contact layer may extend toward the second guiding region and define a second gap in the axial direction between the second metal contact layer and the second guiding region.

With the thickness difference, the surface of the main electrodes away from the semiconductor body may be higher than the surface of the guiding regions of the gate electrodes. Moreover, the metal contact layers attached to the main electrodes can extend toward the guiding regions and define gaps between the metal contact layers and the guiding regions to avoid dangerous arcing.

According to another preferred implementation of the present invention, The protection circuit may further comprise a first gate circuit electrically connected to the first gate electrode and a second gate circuit electrically connected to the second gate electrode The first gate circuit may be configured to supply the gate driving voltage to the first gate electrode to induce the first gate pulse current flowing from the first trigger region to the first emitter region, and the second gate circuit may be configured to supply a gate driving voltage to the second gate electrode to induce a second gate pulse current flowing from the second trigger region to the second emitter region.

The induced gate pulse current can destroy the blocking junctions beneath trigger regions and the emitter regions and turn the bypass semiconductor device into a permanent short circuit. The magnitude of the gate driving voltages may be chosen up to 150 V, preferably, in a range between 15V to 60V, to provide enough energy for the destruction on one hand and to enable practical construction of the gate driver circuit using low-volume low voltage components on the other hand. For special applications, higher gate driving voltage can be used.

The objective is further solved by a MMC cell comprising the protection circuit as discussed above. Specifically, the MMC cell comprises at least two power semiconductor devices, a first cell connection and a second cell connection for connecting with other MMC cells, and the protection circuit as discussed above. The protection circuit is electrically connected between the first cell connection and the second cell connection via the first main electrode and the second main electrode.

Optionally, the MMC cell may be a half bridge cell or a full bridge cell.

As discussed above, the MMC cell is then equipped with the protection circuit which can be switched to a permanent short circuit, regardless of the main electrode's voltage, in response to a single gate signal. Thus, the operational reliability and the fault protection mechanism of the MMC can further be enhanced.

The objective is further solved by a method protecting MMC. The MMC comprises the MMC cell as discussed above, and the method comprises the steps of:
detecting a failure of the MMC cell,
applying gate driving voltages *V_{G}* to the first thyristor structure and the second thyristor structure, and
turning the bypass semiconductor device to the permanent short circuit by damaging the first thyristor structure by the first gate pulse current induced between the first trigger region and the first emitter region and damaging the second thyristor structure by the second gate pulse current induced between the second trigger region and the second emitter region.

Specifically, the semiconductor body may comprise the first blocking junction and the second blocking junction. The step of turning the bypass semiconductor device to the permanent short circuit may be realized by:
turning the bypass semiconductor device to the permanent short circuit by damaging the first blocking junction with the first gate pulse current and damaging the second blocking junction with a second gate pulse current.

Optionally, when the bypass semiconductor device further comprises the breakover diode structure encircling the first and the second thyristor structures. The method may further comprise the step of turning the bypass semiconductor device to the permanent short circuit by punching through or breaking down the breakover diode structure, in response to a voltage *V* between the main electrode exceeding the breakover diode voltage *V_{BO}* of the break over diode structure.

### Brief description of drawings

These and other aspects of the invention will be apparent from and elucidated with reference to the implementations described hereinafter.

In the drawings:
Fig. 1 shows a circuit diagram illustrating a protection circuit with a bypass semiconductor device according to an implementation of the present invention.
Fig. 2 shows a cross-sectional diagram illustrating a bidirectional thyristor structure of the bypass semiconductor device according to an implementation of the present invention.
Fig. 3 shows a cross-sectional diagram illustrating a bidirectional thyristor structure of the bypass semiconductor device according to another implementation of the present invention.
Fig. 4 shows another cross-sectional diagram illustrating the bidirectional thyristor structure depicted in Fig.3.
Fig. 5 shows top view diagram illustrating trigger regions and emitter regions of the bypass semiconductor device according to an implementation of the present invention.
Fig. 6 shows top view diagram illustrating trigger regions and emitter regions of the bypass semiconductor device according to another implementation of the present invention.
Fig. 7 shows top view diagram illustrating first trigger regions and first emitter regions of the bypass semiconductor device according to another implementation of the present invention.
Fig. 8 shows top view diagram illustrating first trigger regions and first emitter regions on a first surface of the bypass semiconductor device according to another implementation of the present invention.
Fig. 9 shows bottom view diagram illustrating second trigger regions and second emitter regions of the bypass semiconductor device according to the implementation depicted in Fig. 8.
Fig. 10 shows a cross-sectional diagram illustrating a bypass semiconductor device with the bidirectional thyristor structure, a breakover diode structure and a junction termination region according to an implementation of the present invention.
Fig. 11 shows an enlarged view of Fig. 10 illustrating the doping profile of the bypass semiconductor device according to an implementation of the present invention.
Fig. 12 shows a cross-sectional diagram illustrating the bypass semiconductor device with electrodes of different thicknesses and corresponding metal contact layers according to an implementation of the present invention.
Fig. 13 illustrates the protection circuit with gate circuits according to another implementation of the present invention.
Fig. 14 illustrates a circuit diagram of a half-bridge MMC cell according to an implementation of the present invention.
Fig. 15 illustrates a circuit diagram of a full-bridge MMC cell according to an implementation of the present invention.
Fig. 16a, Fig. 16b, Fig. 16c and Fig. 16d are circuit diagrams illustrating power semiconductor devices of the MMC cell according to implementations of the present invention.
Fig. 17 is a flow chart of a method for protecting the MMC comprising the MMC cell according to an implementation of the present invention.

### Description of implementations

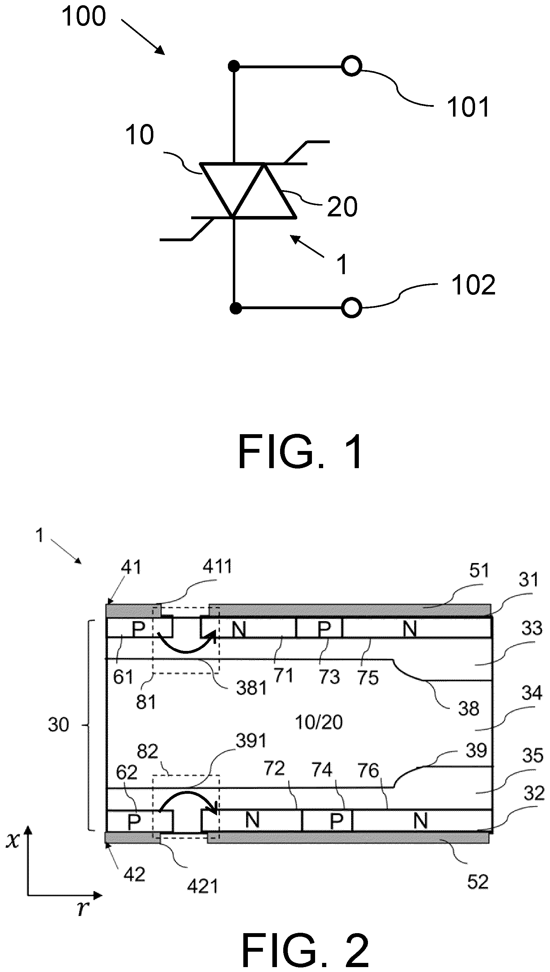

Fig. 1 shows a circuit diagram illustrating a protection circuit 100 comprising a bypass semiconductor device 1 according to an implementation of the present invention. The bypass semiconductor device 1 is a bidirectional thyristor which comprises a first thyristor structure 10 and a second thyristor structure 20 connected in antiparallel.

The protection circuit 100 may further include a first circuit connection 101 and a second circuit connection 102, each with one end electrically connected to different main electrodes of the bypass semiconductor device 1, respectively. The other ends of the first circuit connection 101 and the second circuit connection 102 may be electrically connected to an MMC cell to be protected. In response to a failure of the MMC cell, the bypass semiconductor device 1 may be switched to a permanent short circuit, thereby bypassing the failed MMC cell. It should be noted that the protection circuit 100 can also be connected to and applied for other high-voltage components which requires protection.

Fig. 2 shows a cross-sectional diagram illustrating a bidirectional thyristor structure of the bypass semiconductor device 1 according to an implementation of the present invention. It should be noted that the cross-sectional diagram view is a half-section illustration to clearly present the bidirectional thyristor structure. This bidirectional thyristor structure may be rotationally symmetric at intervals within the bypass semiconductor device.

As depicted in Fig. 2, the bypass semiconductor device 1 comprises a semiconductor body extending in an axial direction *x* with a first surface 31 and a second surface 32 which is opposite to the first surface 32. The first and the second thyristor structure 10/20 share the common semiconductor body 30.

The semiconductor body 30 shown in Fig. 2 comprises a P-N-P structure comprising a first base layer 33 of P-type, a second base layer 34 of N-type and a third base layer 35 of P-type stacked along the axial direction *x.* The base layers may be formed as low-doped N-base and two P-base regions within the semiconductor body 30.

The bypass semiconductor device 1 further comprises a first gate electrode 41 and a first main electrode 51, both disposed on the first surface 31 and spaced from each other, as well as a second gate electrode 42 and a second main electrode 52, both disposed on the second surface 32 and spaced from each other. The first gate electrode 41 and the second gate electrode 42 may be disposed at the centres of the first and second surfaces and extend along a radial direction *r.* The main electrodes may be disposed encircling the gate electrodes.

Although not depicted in Fig. 2, the main electrodes may be insulated from the gate electrodes, preferably, by insulating layers. The first main electrode 51 may function as a cathode for the first thyristor structure 10 and an anode for the second thyristor structure 20, while the second main electrode 52 may function as an anode for the first thyristor structure and a cathode for the second thyristor structure 20.

Fig. 2 further illustrates a first trigger region 61 of P-type is formed in the first base layer 33. The first trigger region 61 faces and is electrically connected to the first gate electrode 41. The first trigger region 61 may have a doping concentration higher than that of the first base layer 33.

Radially opposite to and aligned with the end of the first trigger region 61, a first emitter region 71 of N-type is formed in the first base layer 33. The first emitter region 71 faces and is electrically connected to the first main electrode 51. The first emitter region 71 may be radially spaced from the first trigger region 61 by the first base layer 33. The first emitter region 71 may have a doping concentration higher than that of the first base layer 33. In this implementation, the first trigger region 61 may serve as a gate region of the first thyristor structure, and the first emitter region 71 may serve as a cathode region of the first thyristor structure 10.

Symmetrically, a second trigger region 62 of P-type is formed in the third base layer 35. The second trigger region 62 faces and is electrically connected to the second gate electrode 42. The second trigger region 62 may have a doping concentration higher than that of the third base layer 35.

Radially opposite to and aligned with the end of the second trigger region 62, a second emitter region 72 of N-type is formed in the third base layer 35. The second emitter region 72 faces and is electrically connected to the second main electrode 52. The second emitter region 72 may be radially spaced from the second trigger region 62 by the third base layer 35 and may have a doping concentration higher than the third base layer 35. In this implementation, the second trigger region 62 may serve as a gate region of the second thyristor structure 20 and the second emitter region 72 may serve as a cathode region of the second thyristor structure 20.

As shown in Fig. 2, the first trigger region 61 and the first emitter region 71 may form a first sacrificial region 81 between them, while the second trigger region 62 and the second emitter region 72 may form a second sacrificial region 82 between them accordingly. Dashed lines are only used to virtually mark the sacrificial regions for explanatory purposes. The trigger regions and the emitter regions may have a same thickness or different thicknesses.

When the gates of the thyristor structures are activated by a gate driving voltage *V_{G},* gate pulse current can concentrate and flow from the trigger regions to the emitter regions, leading to a high current density that accurately destroys the blocking junctions in the sacrificial regions from both sides within a short response time. Thus, it is possible to destroy the bypass semiconductor device in response to a single gate pulse without activating the thyristor structures. The arrows shown in Fig. 2 are only used to illustrate the gate pulse current flow direction for explanatory purposes.

Fig. 2 further illustrates that the first gate electrode 41 may comprise a first guiding region 411 extending in the radial direction r on the first surface 31. The first trigger region 61 may extend along with the first guiding region 411 and be electrically connected to the first guiding region 411. The second gate electrode 42 may comprises a second guiding region 421 extending in the radial direction r on the second surface 32. The second trigger region 62 may extend along and be electrically connected to the first guiding region 421.

Moreover, to further reduce the response time and increase the probability of the deconstruction, the blocking junctions may be formed closer to the trigger regions and emitter regions. As shown in Fig. 2, a first blocking junction 38, formed between the first base layer 33 and the second base layer 34, may comprise a first protruding platform 381 extending toward the first trigger region 72 and the first emitter region 71. A second junction 39, formed between the third base layer 35 and the second base layer 34, may also comprise a second protruding platform 391 extending toward the second trigger region 62 and the second emitter region 72.

The protruding platforms, namely the shallower blocking junctions, may be formed at the centre of the semiconductor body extending toward the corresponding trigger regions and at least part of the emitter regions. A distance between the first blocking junction 38 and the first surface 31, as well as a distance between the second blocking junction 39 and the second surface 32 may be ranged from 40 µm to 100 µm. Preferably, the distances may be ranged from 60 µm to 80 µm.

The implementation depicted in Fig. 2 may further comprise a first anode region 74 of P-type and a second anode region 73 of P-type. The second anode region 73 may be formed in the first base layer 33 facing the first main electrode 51. The second anode region 73 may be radially aligned to the first emitter region 71. Specifically, the second anode region 73 may be electrically connected to the first main electrode 51 and have a doping concentration higher than the first base layer 33. Symmetrically, the first anode region 74 may be formed in the third base layer 35 facing the second main electrode 52. The first anode region 74 may be radially aligned with the second emitter region 72. In particular, the first anode region 74 may be electrically connected to the second main electrode 52 and have a doping concentration higher than the third base layer 35.

In this design, the second anode region 73 may function as an anode region of the second thyristor structure, while the first anode region 74 may function as an anode region of the first thyristor structure.

The second and the first anode regions 73/74 may be formed in circular regions respectively encircling the first and the second emitter regions 71 /72. Although not depicted in Fig. 2, the first anode region 73 may be separated from the first emitter region 71 by the first base layer 33 while the second anode region 74 may be radially aligned with and spaced from the second emitter region 72 by the third base layer 35.

Moreover, the emitter and anode regions may have smaller areas compared to standard devices to promote current crowding, intentionally leading to local overloading, which results in the permanent shorting of both blocking junctions and, thereby, the whole bypass semiconductor device 1.

Hence, the structure shown in Fig. 2 may have two distinct operation modes: (a) when the magnitude of a voltage difference *V* between the main electrodes is higher than the gate driving voltage *V_{G}* and (b) when the magnitude of the voltage difference V between the main electrodes is smaller than the gate driving voltage *V_{G}.* The magnitude of *V_{G}* may be chosen from, but is not limited to, 15 V - 150 V, preferably, 15 V - 60 V to provide enough energy for the destruction on one hand and to enable practical construction of the gate drive circuit using low-volume low-voltage components on the other hand.

In operation mode (a), one of the first and the second thyristor structures can be triggered by the gate driving voltage *V_{G}*, similar to conventional thyristor operation. Induced gate pulse currents flow through the P-N-P structures between the gate regions and the cathode regions on both side, and then predominantly through the triggered thyristor P-N-P-N structure. Specifically, the current may first flow laterally from the trigger region to the emitter region and then to the anode region on both sides destroying both blocking junctions. Then, through the triggered thyristor structure, the current flows vertically from the anode region on one surface to the corresponding emitter region on the opposite surface to destroy both blocking junctions, preferably permanently. Which thyristor structure is triggered may depend on the polarity of V. For example, when a voltage level on the first main electrode 51 is sufficiently higher than a voltage level on the second main electrode 52, the second thyristor 20 may be triggered and the second surge current may flow from the second anode region 73 to the second emitter region 72. On the contrary, when a voltage level on the first main electrode 51 is sufficiently lower than a voltage level on the second main electrode 52, the first thyristor 10 may be triggered and the first surge current may flow from the first anode region 74 to the first emitter region 71. The thyristor structure 10 or 20 may be triggered when the magnitude of voltage difference V exceeds a threshold value. The threshold value may be 40V, preferably, 50 V, more preferably, 100V.

In operation mode (b), most of the gate pulse current flows laterally through the P-N-P structure between the gate regions and the cathode regions, thereby destroying both blocking junctions simultaneously. When 0 *< V < V_{G},* one of the thyristor's P-N-P-N structure may be turned on with a very low current density. When *V* = 0, the thyristor structure may be off. The deconstruction leading to the short circuit of the bypass semiconductor device may be achieved only by the lateral currents on both sides. The protection event can be controlled with only a single gate driving signal used for the destructive action at both sacrificial regions 81 and 82.

Optionally, as depicted in Fig. 2, a first blocking region 75 of N-type may be formed in the first base layer 33 encircling the second anode region 73, while a second blocking region 76 of N-type may be formed in the third base layer 35 encircling the first anode region 74. The first blocking region 75 may have a doping concentration higher than the first base layer 33 while the second blocking region 76 may have a doping concentration higher than the third base layer 35. The blocking regions help to secure current crowding in the thyristor structure. Specifically, the anode regions may be formed as circular P-type regions drawn in the N-type regions to resemble large-size cathode shorts.

Although not depicted in Fig. 2, the second anode region 73 may be separated from the first blocking region 75 by the first base layer 33 while the first anode region 74 may be separated from the second blocking region 76 by the third base layer 35. Specific layouts of the trigger regions, emitter regions, and anode regions will be discussed later. The tigger regions, emitter regions, anode regions and blocking regions may have a same thickness or different thicknesses.

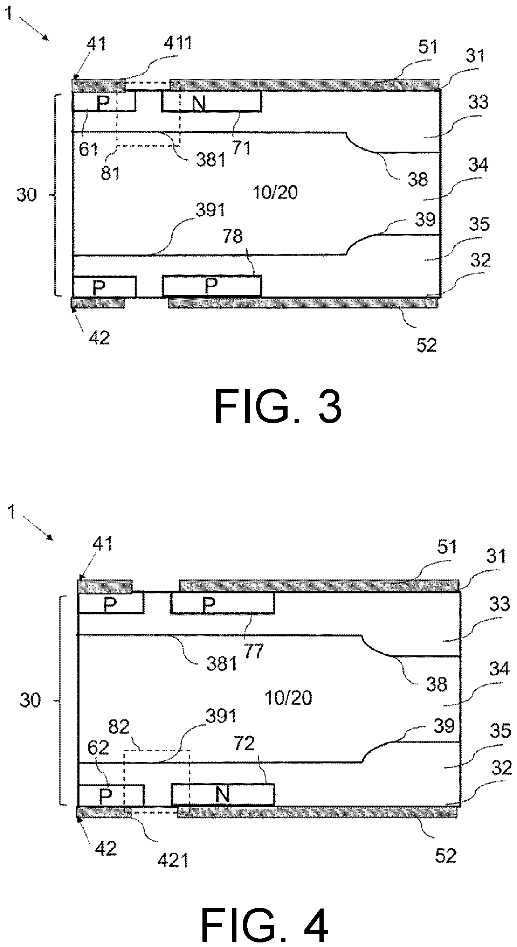

Fig. 3 and Fig. 4 show cross-sectional diagrams illustrating an alternative bidirectional thyristor structure of the bypass semiconductor device 1 according to another implementation of the present invention. Fig. 3 and Fig. 4 depict the cross-sectional diagrams along different radial directions of the bypass semiconductor device 1.

Different from the implementation shown in Fig. 2, when observing along the axial direction x, the first guiding region 411 may be angularly offset from the second guiding region 421 while the first emitter region 71 may be angularly offset from the second emitter region 72 in the same manner. Correspondingly, the trigger regions may be shifted together with the guiding regions.

In this implementation, as shown in Fig. 3, a second anode region 77 of P-type may be formed in the first base layer 33 directly opposite to the second emitter region 72. Correspondingly, as shown in Fig. 4 a first anode region 78 of P-type may be formed in the third base layer 35 directly opposite to the first emitter region 71. The second anode region 77 may have a doping concentration higher than the first base layer 33 while the first anode region 78 may have a doping concentration higher than the third base layer 35.

Consequently, the oppositely arranged first emitter region 71 and first anode region 78 may form the N-P-N-P structure of the first thyristor structure 10 while the oppositely arranged second emitter region 72 and the second anode region 77 may form the N-P-N-P structure of the second thyristor structure 20 for the vertical current flow between the anode regions and the cathode regions. The specific layout of N/P masks forming the trigger regions, the emitter regions and the anode regions on both surfaces will be described later. The tigger regions, emitter regions and anode regions may have a same thickness or different thicknesses.

For both implementations shown in Fig. 2, Fig. 3 and Fig. 4, the bypass semiconductor device 1 may comprise multiple guiding regions extending in different radial directions as well as multiple pairs of trigger and emitter regions that are radially spaced and distributed along the bypass semiconductor device 1. Hence, the bypass semiconductor device 1 may comprise multiple sacrificial regions 81/82 where the blocking junctions could be destroyed by the gate pulse currents.

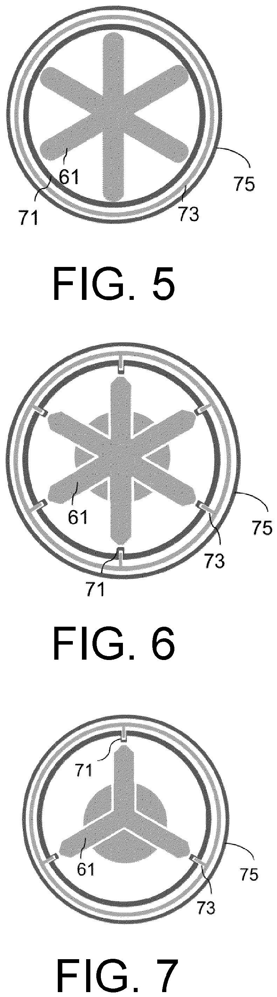

The number of the first and the second sacrificial regions ranges between 2 and 8, preferably, between 3 and 6. The sacrificial regions 81/82 may be evenly distributed along the bypass semiconductor device 1 so that it can be destroyed in a balanced manner. Fig. 5 to Fig. 9 depict top view or bottom view diagrams illustrating the layouts of the trigger regions and the emitter regions according to different implementations of the present invention. Fig. 5 to Fig. 9 show only the internal part of the thyristor structure. Much larger peripheral region outside the thyristor structures may constitute the break-over diode.

Fig. 5 depicts a layout of the first trigger regions 61 and the first emitter regions 71 according to the implementation shown in Fig. 2 when viewing from the first surface 31. As shown in Fig. 5, the bypass semiconductor device 1 may comprise six first trigger regions 61 extending in different radial directions and evenly distributed along the bypass semiconductor device 1. An included angle between two adjacent first trigger regions 61 may be 60°. The first emitter region 71 may be formed to encircle the six first trigger regions 61 to form six corresponding first sacrificial regions 81. The first emitter regions 71 may be spaced from the edge of the first trigger regions 61 by the first base layer 33. Additionally, and optionally, the second anode region 73 may be formed in a circular region encircling the first emitter region while the first blocking region 75 may be formed in a circular region encircling the second anode region 73. The first emitter region 71, the first anode region 73 and the first blocking region may be spaced from each other by the first base layer. Further, widths of the first emitter region, the first anode region 73 and the first blocking region 75 may be substantially smaller than radial extensions of the first trigger regions 61 so as to enhance local current crowding. Although not depicted in the figures, the same layout may be provided symmetrically for the second trigger regions 62, the second emitter region 72, the first anode region 74 and the second blocking region 76 on the second surface 32 of the bypass semiconductor device 1.

Fig. 6 depicts an alternative layout of the first trigger regions 61 and the first emitter regions 71 according to the implementation shown in Fig. 2 when viewed from the first surface 31. Different from the layout shown in Fig. 5, each first trigger region 61 extends radially and gradually narrows at its end. That is, the end of the first trigger region 61 is narrower than the main portion of the first trigger region 61. This design may facilitate current crowding.

Correspondingly, the first emitter region 71 may comprise a circular region encircling the six first trigger regions 61 and six protruding regions that extend toward the ends of the first trigger regions 61 to form six corresponding first sacrificial regions 81. This design further facilitates the crowding of current between the first trigger regions 61 and the first emitter regions 71. It should be noted that the first emitter regions 71, in particular, the protruding regions may still be spaced from the edge of the first trigger regions 61 by the first base layer 33.

In addition, the second anode region 73 may be formed in a circular region encircling the first emitter region, while the first blocking region 75 may be formed in a circular region encircling the second anode region 73. The second anode region 73 may also comprise protruding regions that extend toward the protruding regions of the first emitter region 71.

The first emitter region 71, the second anode region 73, and the first blocking region may be spaced from each other by the first base layer. Optionally, floating P-type regions may be provided between the adjacent first trigger regions 61. The floating regions may also be spaced from the first trigger regions 61 by the first base layer 33 and have a doping concentration higher than that of the first base layer 33.

Although not depicted in the figures, the same layout may be provided symmetrically for the second trigger regions 62, the second emitter regions 72, the second anode region 74 and the second blocking region 76 on the second surface 32 of the bypass semiconductor device 1. Fig. 6 shows only the internal part of the thyristor structure. Much larger peripheral region outside the thyristor structures may constitute the break-over diode.

Fig. 7 depicts a layout similar to the layout shown in Fig. 6 with the difference that the bypass semiconductor device 1 comprises three first trigger regions. It is noted that the number of the trigger regions and the corresponding sacrificial regions may be chosen based on practical requirements. The number may range from 2 to 8, preferably from 3 to 6, but it is not limited to the number.

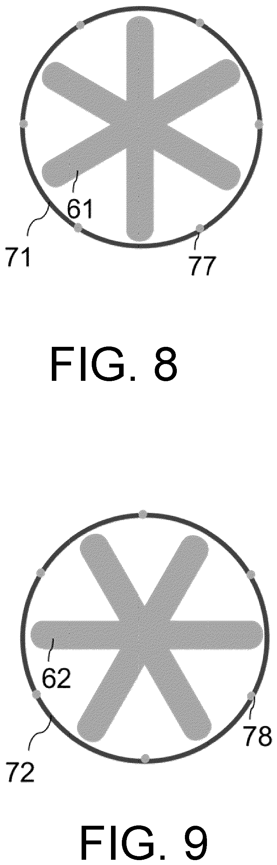

Fig. 8 and Fig. 9 show the respective layouts of the trigger regions and the emitter regions on the first surface 31 and the second surface 32 according to the implementation shown in Fig. 3 and Fig. 4. As shown in Fig. 8, the bypass semiconductor device 1 may comprise six first trigger regions 61 extending in different radial directions and evenly distributed along the bypass semiconductor device 1. An included angle between two adjacent first trigger regions 61 may be 60°.

The first emitter region 71 may comprise a circular region encircling the six first trigger regions, whereby the first trigger regions 61 form the corresponding sacrificial regions 81 with portions of the first emitter region 71 aligned with the ends of the first trigger regions 61. Six second anode regions 77 may be interlaced within the first emitter region 71 between two adjacent portions aligned with the ends of the first trigger regions 61. In other words, the second anode regions 77 may be formed aligned with a midpoint between two adjacent first trigger regions 61. At the same time, as shown in Fig. 9, the same N/P mask that forms the six second trigger regions 62, the second emitter region 72, and the six first anode regions 78 may be applied to the second surface and may be mutually offset with respect to the first trigger regions 61 by an angle. The offset angle may be 30°.

With the mutual offset, the second anode regions 77 may be axially aligned with the portions of the second emitter region 72 that radially aligned with the ends of the first trigger regions 62 to provide the P-N-P-N structure of the second thyristor structure 20. The first anode regions 78 may be axially aligned with the portions of the first emitter region 71 that radially aligned with the ends of the first trigger regions 61 to provide the P-N-P-N structure of the first thyristor structure 10.

Although not depicted in Fig. 8 and Fig. 9, the first and second emitter regions may also comprise protruding regions that extend toward the ends of the trigger regions as shown in Fig. 6. Optionally, the trigger regions may also comprise narrower ends, as shown in Fig. 6, to facilitate current crowding.

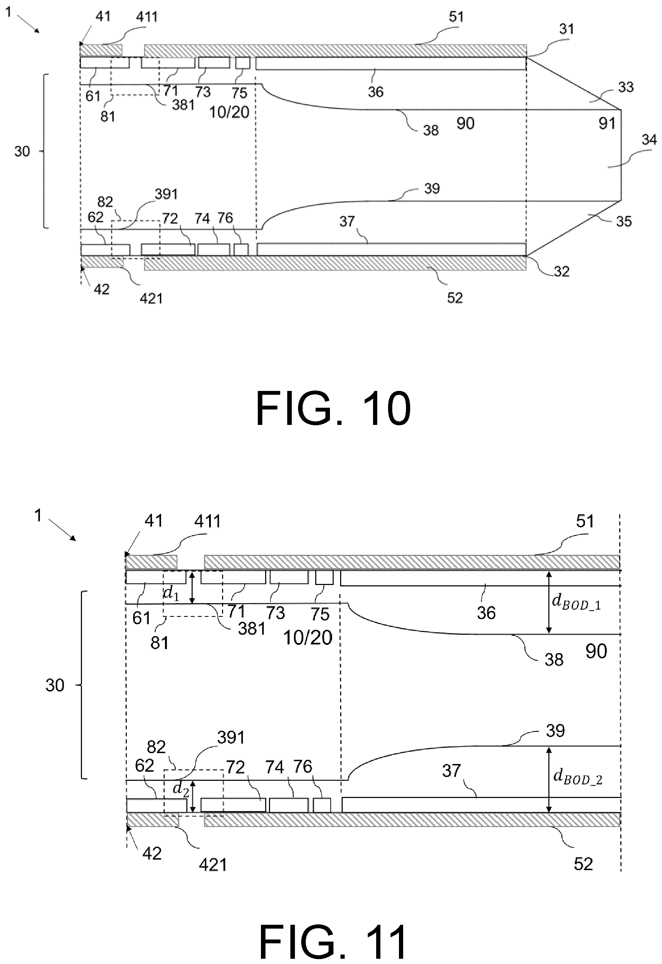

Fig. 10 shows a cross-sectional diagram illustrating the bypass semiconductor device 1 with the bidirectional thyristor structure 10/20, a breakover diode structure 90 and a junction termination region 91 according to an implementation of the present invention.

As shown in Fig. 10, the bypass semiconductor device 1 may further comprise the breakover diode structure 90 encircling the first and the second thyristor structures 10 and 20. That is, the breakover diode structure 70 may share the semiconductor body 30 with the thyristor structures.

As shown in Fig. 10, the semiconductor body 30 may further comprise a third trigger region 36 of P-type disposed in the first base layer 33 facing the first main electrode 51. A fourth trigger region 37 of P-type may be formed in the third base layer 35 facing the second main electrode 52. The fourth trigger region 37 may be formed in a circular region encircling the second emitter region 72. The third and fourth trigger regions may have the same or different thicknesses as the first and second trigger regions.

To facilitate current crowding in the thyristor structure, the third trigger region 36 may be spaced from the first emitter region 71 while the fourth trigger region 37 may be spaced from the second emitter region 72. As shown in Fig. 10, when the implementation of the thyristor structures 10/20 illustrated in Fig. 2 is employed, the third trigger region 36 may be spaced from the first blocking region 75 by the first base layer 33 while the fourth trigger region 37 may be spaced from the second blocking region 76 by the third base layer 35. Alternatively, when the implementation of the thyristor structures illustrated in Fig. 3 and Fig. 4 is employed, the third trigger region 36 may be spaced from the first emitter region 71 and the third anode region 77 by the first base layer 33 while the fourth trigger region 37 may be spaced from the second emitter region 72 and the fourth anode region 78 by the third base layer 35.

Optionally, the third trigger region 36 may have a doping concentration higher than the first base layer 33 and equal to or lower than the first trigger region 61. The fourth trigger region 37 may have a doping concentration higher than the third base layer 35 and equal to or lower than the second trigger region 62. The third trigger region 36 and the fourth trigger region 37 may have widths significantly larger than the widths of the emitter regions and the anode regions, for instance, at least twice as large.

A breakover voltage *V_{BO}* of the diode may be adjusted by properly choosing the resistivity of starting silicon wafer in combination with wafer thickness. For specific applications, the breakover voltage *V_{BO}* may be a few hundred volts lower than a breakdown voltage of a power semiconductor device, such as an IGBT, to be protected. The breakover voltage *V_{BO}* may be ranged from 4000 V to 6000 V. Preferably, the breakover voltage *V_{BO}* may be 5000V ± 50 V. In this way, the breakover diode structure 90 may work as an emergency brake. If the thyristor structures do not fail into a short circuit, the breakover diode may be subjected to punch-through or breakdown effect with a sufficient high main electrode voltage *V.*

As further depicted in Fig. 10, the semiconductor body 30 may comprise the junction termination region 91 encircling the breakover diode structure 90. The junction termination region 91 may extend outside an outer circumference of the first main electrode 51 and an outer circumference of the second main electrode 52. Specifically, the junction termination region 91 may have a reverse breakdown voltage *V_{BR}* a few hundred volts higher than the breakover voltage *V_{BO}* of the breakover diode structure 90.

Hence, the breakdown of the diode 90 may only happen within the bulk and not inside the junction termination region 91, thereby avoiding arcing at the periphery of the semiconductor body, which could lead to an explosion. This can be achieved by high-energy electron radiation in the area of the junction termination region 91. The effect of the electron irradiation, which results in *V_{BR} > V_{BO},* consists of the reduced diffusion length of free carriers under the reverse bias of the open base P-N-P transistor structure in the electron irradiated region.

According to the implementation of Fig. 10, a vertical thickness of the semiconductor body 30 is gradually reduced from the outer circumferences of the first and the second main electrodes 51 and 52 to a circumferential side of the semiconductor body 30, thereby forming negative bevels for the junction termination region 91.

As discussed above, to increase the probability of deconstruction, at least part of the thyristor structures 10/20 may comprise shallower blocking junctions. Fig. 11 shows an enlarged view of Fig. 10 illustrating the doping profile according to this implementation of the present invention. It can be seen from Fig. 11 that a depth *d*₁ of the first blocking junction 38 to the first surface 31 in the first sacrificial region 81 may be smaller than a depth *d*_{*BOD_*1} of the first blocking junction in the breakover diode structure 90. Symmetrically, a depth *d*₂ of the second blocking junction 39 to the second surface 32 in the first sacrificial region 82 may be smaller than the depth *d*_{*BOD_*2} of the second blocking junction in the breakover diode structure 90.

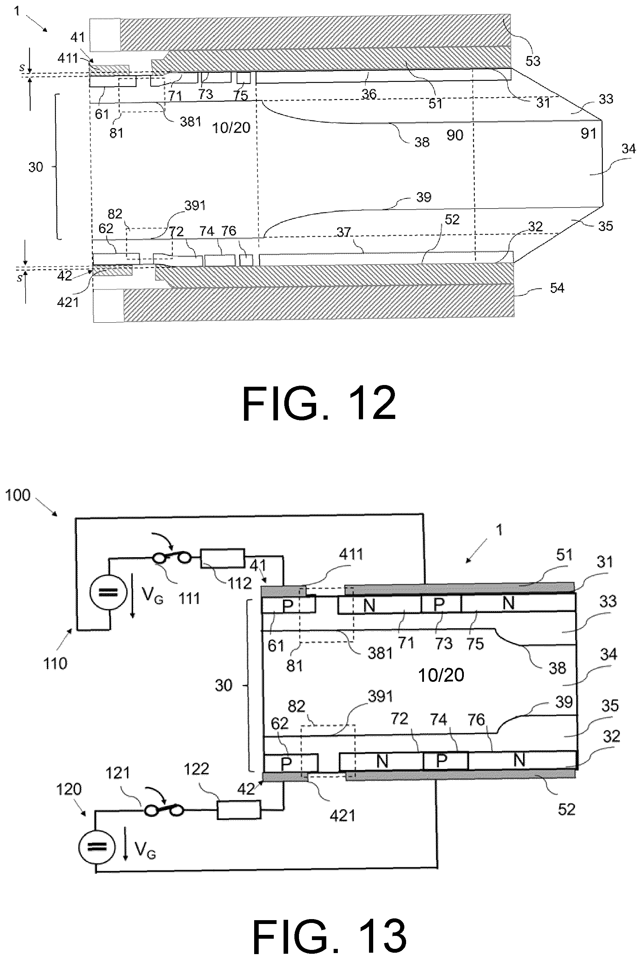

The shallower blocking junctions may be realized by the pre-deposition of an aluminium mask and wet etching. To bring the blocking junctions closer to the surfaces of the thyristor structures in the axial direction, the diffusion species may be locally etched away using a mask before their drive-in, resulting in the creation of etching steps with heights ranging from 5 to 10 µm, as shown in Fig. 12.

Fig. 12 shows a cross-sectional diagram illustrating the bypass semiconductor device 1 with electrodes of different thicknesses and corresponding metal contact layers according to an implementation of the present invention.

As shown in Fig. 12, a thickness of the first main electrode 51 is larger than that of the first guiding region 411, and a thickness of the second main electrode 52 is larger than that of the second guiding region 421. It can be observed that the guiding regions of the gate electrodes are axially lower than the main electrodes. This may be achieved by a two-step masked formation of metal layers. First, a first metal layer may be formed in the centre portion of the gate electrodes and the main electrodes, then a second metal layer may be formed in the gate electrodes including the guiding regions and the main electrodes. In this way, the main electrodes may comprise two metal layers while the guiding regions may only comprise one metal layer, thereby creating the height difference. The metal layers may be made of copper, silver, titanium, nickel, aluminium, or stacks comprising at least two layers made of titanium, nickel, silver, and/or aluminium.

Optionally, the bypass semiconductor device 1 may further comprise a first metal contact layer 53 attached to the first main electrode 51 and a second metal contact layer 54 attached to the second main electrode 52. The metal contact layers may be made of molybdenum, silver, or other material with similar coefficient of thermal expansion as that of a silicon wafer forming the semiconductor body 30. The first metal contact layer 53 may extend toward the first guiding region 411, thereby covering and defining a first gap in the axial direction between the first metal contact layer 53 and the first guiding region 411, and the second metal contact layer 54 may extend toward the second guiding region 421, thereby covering and defining a second gap in the axial direction between the second metal contact layer 54 and the second guiding region 421. The metal contact layers may comprise through holes at their centres so that other components or circuits may connect to the centres of the gate electrodes via the through holes.

With this embodiment, the sacrificial regions 81/82 between the trigger regions and the emitter regions may be covered by the metal contact layers, thereby protecting an encapsulation or housing of the bypass semiconductor device 1 from dangerous arcing that may appear during burning of the metal contact layers during destruction of the thyristor structures.

Fig. 13 illustrates a protection circuit 100 according to another implementation of the present invention. The protection circuit 100 may further a first gate circuit 110 electrically connected to the first gate electrode 41 and the first main electrode 51, and a second gate circuit 120 electrically connected to the second gate electrode 42 and the first main electrode 52.

The first gate circuit 110 may be configured to supply the gate driving voltage *V_{G}* to the first gate electrode 41 to induce the first gate pulse current flowing from the first trigger region 61 to the first emitter region 71. The second gate circuit 120 may be configured to supply the gate driving voltage *V_{G}* to the second gate electrode 42 to induce the second gate pulse current flowing from the second trigger region 62 to the second emitter region 72. The gate pulse currents thereby destroy the blocking junctions beneath the trigger regions and the emitter regions, creating a low-resistance path between the two main electrodes. The triggering may also be performed via an electrical or optical signal brought into the two gates at the same time.

The gate voltage *V_{G}* may be chosen up to 300 V, preferably, up to 150 V, more preferably, in a range of 15 V to 60 V such as 20 V, 30V, 40 V and 50 V. The first gate circuit 110 may comprise a gate capacitor, a switch 111 and a regulating component 112. The first gate circuit 120 may comprise a gate capacitor, a switch 121 and a regulating component 122. The regulating component may be a resistor, an inductor or other commonly used regulating components. The protection circuit 100 may be applied to MMC cells. Alternatively, the bidirectional thyristor as shown in Fig. 3 can also be employed. Although not depicted in Fig. 13, the bypass semiconductor device 1 may comprise the breakover diode structure 90 and the junction termination region 91 as shown in Fig.10 and Fig. 12.

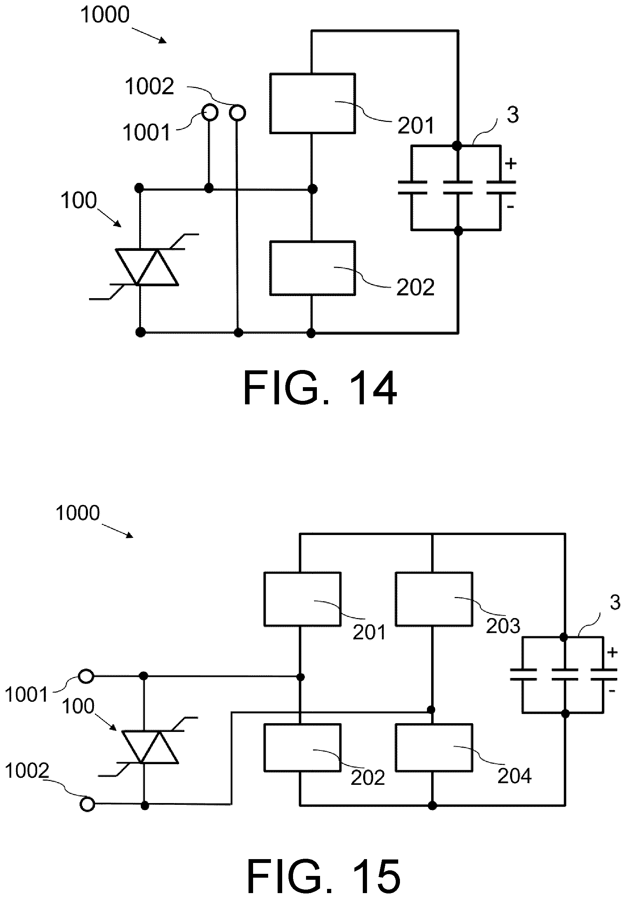

Fig. 14 illustrates a circuit diagram of a half-bridge MMC cell 1000 according to an implementation of the present invention.

The MMC cell 1000 is configured as a half-bridge cell comprising a first power semiconductor device 201, a second power semiconductor device 202 and a power storage component 3 connected in series. The MMC cell 1000 further comprises a first cell connection 1001 and a second cell connection 1002 for connecting with other MMC cells. The first cell connection 1001 may be electrically connected between the first power semiconductor device and the second power semiconductor device 202. The second cell connection 1002 may be electrically connected between the second power semiconductor device 202 and the power storage component 3. The power storage component 3 may be a cell capacitor.

The power semiconductor devices 201/202 may be semiconductor switches. The power semiconductor devices 201/202 may be a bipolar-type or MOSFET-type switch. The power semiconductor devices 201/202 may comprise an IGBT, a reverse conducting IGBT (RC-IGBT), a Bi-mode Insulated Gate Transistor (BiGT), a Gate Turn-Off Thyristor (GTO), an Integrated Gate-Commutated Thyristor (IGCT), a Metal-Oxide-Semiconductor Field-Effect Transistor (MOSFET), and/or other similar devices.

Additionally, the power semiconductor devices 201 and 202 may feature a press-pack design, such as a press-pack IGBT, press-pack RC-IGBT or BiGT with an internal free-wheeling diode, or a press-pack IGCT. However, it should be understood that other semiconductor switches may also be used depending on practical requirements.

Further, as shown in Fig. 14, the MMC cell 1000 comprises the protection circuit 100 as described above. The protection circuit 100 is electrically connected between the first cell connection 1001 and the second cell connection 1002 via the first main electrode 51 and the second main electrode 52, preferably via the corresponding metal layers 53 and 54.

In this regard, the bypass semiconductor device 1 is connected in parallel with the second power semiconductor device 202. When the bypass semiconductor device is featured with the breakover diode structure 90, the breakover voltage *V_{BO}* may be a few hundred volts lower than a rating breakdown voltage of a power semiconductor device 202. The breakover voltage *V_{BO}* may be lower than the rated breakdown voltage of a power semiconductor device 202 by 100 V to 900 V, preferably by 200 V to 500 V, but it is not limited to this range. In this way, the breakover diode structure 90 may work as an emergency brake. If the thyristor structures do not fail into a short circuit, the breakover diode may be subjected to punch-through or breakdown effect with a sufficient high main electrode voltage *V.*

In response to a failure of the MMC cell 1000 or other cells, gate voltages or gate signals may be applied simultaneously to both gates of the bypass semiconductor devices 100, thereby turning the bidirectional thyristor structure into a permanent short circuit, with the induced gate pulse currents flowing from the trigger regions 61/62 to the emitter regions 71/72. The protection circuit 100 and the bypass semiconductor device 1 may have a same configuration and design as any of the implementations as described above.

Optionally, the MMC cell 1000 may further comprise a mechanical switch connected in parallel to the bypass semiconductor device 100.

Fig. 15 illustrates a circuit diagram of a full-bridge MMC cell according to an implementation of the present invention. Compared to the half-bridge MMC cell, the full-bridge MMC cell further comprises a third power semiconductor device 203 and a fourth power semiconductor device 204. One end of the power storage element 3 may be connected between the first and third power semiconductor devices.

Another end of the power storage element may be connected between the second and the fourth power semiconductor device.

In this implementation, the first cell connection 1001 may be provided between the first power semiconductor device and the second power semiconductor device 202 while the second cell connection 1002 may be provided between the third power semiconductor device 203 and the fourth power semiconductor device 204. The power storage component 3 may also be a cell capacitor.

As shown in Fig. 15, the protection circuit 100 is electrically connected between the first cell connection 1001 and the second cell connection 1002 via the first main electrode 51 and the second main electrode 52, preferably via the corresponding metal layers 53 and 54.

When the bypass semiconductor device is featured with the breakover diode structure 90, the breakover voltage *V_{BO}* may be a few hundred volts lower than a maximum allowable voltage between the first and second cell connections.

Optionally, the MMC cell 1000 may further comprise a mechanical switch connected in parallel to the bypass semiconductor device 100.

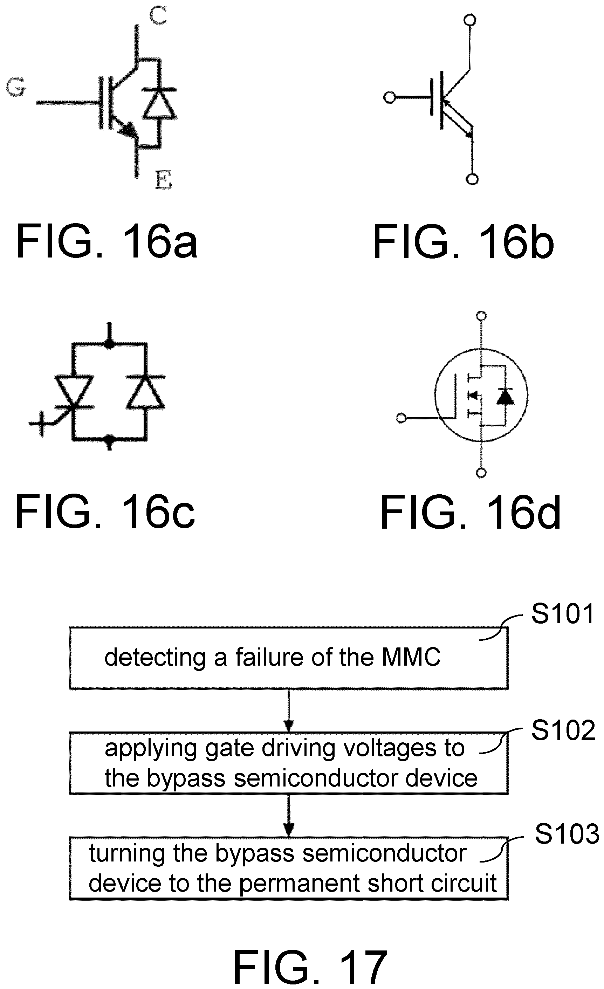

Fig. 16a illustrates an IGBT with an antiparallel fast-recovery diode (FRD), which may serve as the power semiconductor device for the MMC cell 1000. The IGBT and the FRD may be provided on separate chips. Fig. 16b illustrates a BiGT, which may serve as the power semiconductor device for the MMC cell 1000. Fig. 16c illustrates an IGCT with an antiparallel FRD, which may serve as the power semiconductor device for the MMC cell. Fig. 16d illustrates a MOSFET, which may serve as the power semiconductor device for the MMC cell. In addition, the power semiconductor device may be an RC-IGBT comprising an antiparallel FRD integrated within the same wafer.

Fig. 17 is a flow chart of a method for protecting the MMC comprising the MMC cell as described above according to an implementation of the present invention. The method may be applied to any MMC employing the protection circuit 100 according to any implementations as described above.

The method comprises the following steps of:
S101: detecting a failure of the MMC cell 1000,
S102: applying gate driving voltages *V_{G}* to the first thyristor structure 10 and the second thyristor structure 20, and
S103: turning the bypass semiconductor device 1 to the permanent short circuit by damaging the first thyristor structure 10 with the first gate pulse current induced between the first trigger region 61 and the first emitter region 71 and damaging the second thyristor structure 20 with the second gate pulse current induced between the second trigger region 62 and the second emitter region 72.

As described above, due to the provision of trigger regions and emitter regions, it is possible to destroy the bidirectional thyristor structure from both sides simultaneously regardless of the voltage between the main electrodes. Thus, it is possible to bypass the MMC cell under arbitrary fault conditions, specifically during the "black start", and enable reliable protection of the MMCs.

Specifically, the step of turning (S103) the bypass semiconductor device 1 to the permanent short circuit may be implemented by:
S1031: turning the bypass semiconductor device 1 to the permanent short circuit by damaging the first blocking junction 38 with the first gate pulse current and damaging the second blocking junction 39 with a second gate pulse current.

When the magnitude of the voltage *V* between the main electrodes is higher than the gate driving voltage *V_{G}*, the step of turning (S103) the bypass semiconductor device 1 to the permanent short circuit may further comprise:
S1032: turning the bypass semiconductor device 1 to the permanent short circuit by damaging the blocking junctions with the first surge current between the first anode region 74/78 and the first emitter region 71, or
S1033: turning the bypass semiconductor device 1 to the permanent short circuit by damaging the blocking junctions with the second surge current between the second anode region 73/77 and the second emitter region 72.

Which step will be executed may be determined based on the polarity of the main electrode voltage *V.* Specifically, when the voltage level in the first main electrode 51 is higher, step S1033 may be executed. When the voltage level in the second main electrode 52 is higher, step S1032 may be executed.

According to a preferred implementation of the present invention, when the bypass semiconductor device further comprises a breakover diode structure 90, the method may further comprise:
S104: turning the bypass semiconductor device 1 to the permanent short circuit by punching through or breaking down the breakover diode structure 90, in response to a voltage V between the main electrode exceeding a breakover diode voltage *V_{BO}* of the break over diode structure.

The breakover diode structure may serve as an emergency break.

While the invention has been illustrated and described in detail in the drawings and foregoing description, such illustration and description are to be considered illustrative or exemplary and not restrictive; the invention is not limited to the disclosed implementations. Other variations to be disclosed implementations can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope. The figures are for illustrative purposes only and are not scalable.

### Reference signs list

1 bypass semiconductor device
3 power storage component
10 first thyristor structure
20 second thyristor structure
30 semiconductor body
31 first surface
32 second surface
33 first base layer
34 second base layer
35 third base layer
36 third trigger region
37 fourth trigger region
38 first blocking junction
381 first protruding platform
39 second blocking junction
391 second protruding platform
41 first gate electrode
411 first guiding region
42 second gate electrode
421 second guiding region
51 first main electrode
52 second main electrode
53 first metal contact layer
54 second metal contact layer
61 first trigger region
62 second trigger region
71 first emitter region
72 second emitter region
73 second anode region
74 first anode region
75 first blocking region
76 second blocking region
77 second anode region
78 first anode region
81 first sacrificial region
82 second sacrificial region
90 breakover diode structure
91 junction termination region
100 protection circuit
101 first circuit connection
102 second circuit connection
110 first gate circuit
111 first switch
112 first regulating impedance
120 second gate circuit
121 second switch
122 second regulating impedance
201 first power semiconductor device
202 second power semiconductor device
203 third power semiconductor device
204 fourth power semiconductor device
1000 MMC cell
1001 first cell connection
1002 second cell connection

## Claims

1. A protection circuit (100) for a modular multilevel converter, MMC, comprising a bypass semiconductor device (1), which comprises:
a semiconductor body (30) extending in an axial direction with a first surface (31) and a second surface (32),
a first thyristor structure (10) and a second thyristor structure (20) antiparallel connected to each other and sharing the semiconductor body (30),
a first gate electrode (41) and a first main electrode (51) disposed on the first surface (31) and spaced from each other, and
a second gate electrode (42) and a second main electrode (52) disposed on the second surface (32) and spaced from each other, whereby
the first thyristor structure (10) comprises a first trigger region (61) facing and electrically connected to the first gate electrode (41) and a first emitter region (71) facing and electrically connected to the first main electrode (51),
the second thyristor structure (20) comprises a second trigger region (62) facing and electrically connected to the second gate electrode (42) and a second emitter region (72) facing and electrically connected to the second main electrode (52), and
in response to gate driving voltages *V_{G}* applied to the first gate electrode (41) and the second gate electrode (42), the first thyristor structure (10) is configured to fail to a permanent short circuit by a first gate pulse current induced between the first trigger region (61) and the first emitter region (71), while the second thyristor structure (20) is configured to fail to a permanent short circuit by a second gate pulse current induced between the second trigger region (62) and the second emitter region (72).

2. The protection circuit (100) according to any one of the previous claims, wherein
the first thyristor structure (10) comprises a first anode region (74, 78) facing and electrically connected to the second main electrode (52),
the second thyristor structure (20) comprises a second anode (73, 77) region facing and electrically connected to the first main electrode (51),
if a magnitude of voltage *V* between the first main electrode (51) and the second main electrode (52) is larger than the gate driving voltages *V_{G}* applied to the first trigger region (61) and the second trigger region (62), and
the first thyristor structure (10) is further configured to fail to the permeant short circuit by a first surge current between the first anode region (74, 78) and the first emitter region (71), or
the second thyristor structure (20) is further configured to fail to short by a second surge current between the second anode region (74, 78) and the second emitter region (72).

3. The protection circuit (100) according to any one of the pervious claims,
the first gate electrode (41) comprises a first guiding region (411) extending in a radial direction on the first surface (31),
the first trigger region (61) extends along and is electrically connected to the first guiding region (411), and
the second gate electrode (42) comprises a second guiding region (421) extending in a radial direction on the second surface (32),
the second trigger region (62) extends along and is electrically connected to the first guiding region (421).

4. The protection circuit (100) according to any one of the previous claims, wherein,
the first thyristor structure (10) comprises multiple first trigger regions (61) and multiple first emitter regions (71) in the semiconductor body (30), and
the second thyristor structure (20) comprises multiple second trigger regions (62) and multiple second emitter regions (72) in the semiconductor body (30).

5. The protection circuit (100) according to any one of the previous claims, wherein the bypass semiconductor device (1) further comprises
a breakover diode structure (90) encircling the first and the second thyristor structures (10, 20), whereby the breakover diode structure (90) is configured to be punched through when the voltage *V* between the first and the second main electrodes (10, 20) exceeds the breakover voltage *V_{BO}.*

6. The protection circuit (100) according to the previous clam, wherein the bypass semiconductor device (1) further comprises a junction termination region (91) encircling the breakover diode structure (90), whereby the junction termination region (91) has a reverse breakdown voltage *V_{BRJ}* higher than the breakover voltage *V_{BO}* of the breakover diode structure (90).

7. The protection circuit (100) according to any one of the previous claims, wherein
the semiconductor body (30) comprises a first blocking junction (38) and a second blocking junction (39),
the first blocking junction (38) comprises a first protruding platform (381) toward the first trigger region (61) and the first emitter region (71), and
the second blocking junction (39) comprises a second protruding platform (391) toward the second trigger region (62) and the second emitter region (72).

8. The protection circuit (100) according to any one of the previous five claims, wherein,
a thickness of the first main electrode (51) is larger than a thickness of the first guiding portion (411), and
a thickness of the second main electrode (52) is larger than a thickness of the second guiding portion (421).

9. The protection circuit (100) according to any one of the previous claims, wherein,
the bypass semiconductor device (1) further comprises a first metal contact layer (53) attaching to the first main electrode (51) and a second metal contact layer (54) attaching to the second main electrode (52),
the first metal contact layer (53) extends toward the first guiding region (411), defining a first gap in the axial direction between the first metal contact layer (53) and the first guiding region (411), and
the second metal contact layer (54) extends toward the second guiding region (421), defining a second gap in the axial direction between the second metal contact layer (54) and the second guiding region (421).

10. The protection circuit (100) according to any one of the previous claims, further comprising:
a first gate circuit (110) electrically connected to the first gate electrode (41), and
a second gate circuit (120) electrically connected to the second gate electrode (42).

11. A modular multilevel converter, MMC, cell (1000) comprising at least two power semiconductor devices (201, 202),
a first cell connection (1001) and a second cell connection (1002) for connecting with other MMC cells, and
the protection circuit (100) according to any one of the previous claims, wherein,
the protection circuit (100) is electrically connected between the first cell connection (1001) and the second cell connection (1002) via the first main electrode (51) and the second main electrode (52).

12. The MMC cell (1000) according to the previous claim, wherein the MMC cell (1000) is a half-bridge cell or a full-bridge cell.

13. A method for protecting MMC comprising a MMC cell (1000) according to any of the previous two claims, whereby the method comprises the steps of:
detecting (S101) a failure of the MMC cell (1000),
applying (S102) gate driving voltages *V_{G}* to the first thyristor structure (10) and the second thyristor structure (20), and
turning (S103) the bypass semiconductor device (1) to the permanent short circuit by damaging the first thyristor structure (10) by the first gate pulse current induced between the first trigger region (61) and the first emitter region (71) and damaging the second thyristor structure (20) by the second gate pulse current induced between the second trigger region (62) and the second emitter region (72).

14. The method according to the previous claim, wherein
the semiconductor body (30) comprises the first blocking junction (38) and the second blocking junction (39), and
the step of turning (S103) the bypass semiconductor device (1) to the permanent short circuit comprises:
turning (S1031) the bypass semiconductor device (1) to the permanent short circuit by damaging the first blocking junction (38) with the first gate pulse current and damaging the second blocking junction (39) with a second gate pulse current.

15. The method according to the previous claim, wherein
the bypass semiconductor device (1) further comprises the breakover diode structure (90) encircling the first and the second thyristor structures (10, 20), and
the method further comprises the step:
turning (S104) the bypass semiconductor device (1) to the permanent short circuit by punching through or breaking down the breakover diode structure (90), in response to a voltage *V* between the main electrode exceeding a breakover diode voltage *V_{BO}* of the break over diode structure (90).
